(19) Europäisches Patentamt
European Patent Office
Office européen des brevets

(11) **EP 4 358 409 A1**

(12) **EUROPEAN PATENT APPLICATION**

(43) Date of publication:
**24.04.2024 Bulletin 2024/17**

(21) Application number: **22202622.1**

(22) Date of filing: **19.10.2022**

(51) International Patent Classification (IPC):
*H03K 19/00* (2006.01)   *G01R 19/165* (2006.01)

(52) Cooperative Patent Classification (CPC):
**H03K 19/0019**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Metis Microsystems, LLC**
**Newtown, CT 06470 (US)**

(72) Inventor: **BHAVNAGARWALA, Azeez**
**Newtown, 06470 (US)**

(74) Representative: **Cooley (UK) LLP**
**22 Bishopsgate**
**London EC2N 4BQ (GB)**

(54) **CIRCUITS AND METHODS TO USE ENERGY HARVESTED FROM TRANSIENT ON-CHIP DATA**

(57)   Circuits and methods that use harvested electrostatic energy from transient on-chip data are described. In one aspect, a method inverter circuit use harvested electrostatic charge held at any electric potential higher than the common ground reference potential of CMOS circuits in a chip, to partially drive a 0→1 logic transition at the output of the inverter at lower energy drain from the on-chip power grid than a conventional CMOS inverter with similar performance, slew rates at inverter input and output and with similar output driving transistor geometries.

Figure 3

EP 4 358 409 A1

**Description**

**Field**

The present disclosure relates to use of electrostatic energy harvested from transient on-chip data to improve the energy efficiency of digital CMOS circuit operation.

**Background**

In recent years, deep neural networks (DNNs) have become the solution for many AI applications including computer vision, speech recognition and robotics implementing machine learning methods. While these neural networks deliver sufficient accuracy - it comes at the cost of high computational complexity with associated power drain limiting deep learning from being deployed on mobile devices with limited energy budgets. Smart phones for example, cannot run object classification with AleXNet in real-time for more than an hour. Network issues of latency, bandwidth and availability could require battery/ambient powered IoT devices on the edge to not only sense and act without communicating to the cloud but also to take on more computationally intense tasks of learning or training a neural network. Neural networks for a myriad of IoT devices can easily result in model sizes that are enormous - becoming computationally burdensome to their energy resources, demanding energy budgets that exceed provisions from batteries and conventional energy harvesting methods. Even where power is abundantly available as in a data center supporting AI workloads, where GPU accelerators consume as much as 400W, the cost of electricity and the performance limits imposed by heat removal efficiency can be improved by lowering the switching (or Dynamic) energy consumption of digital CMOS circuits.

In many applications requiring high speed CMOS circuit operation, precharged dynamic circuit techniques are preferred. These circuits are typically operated by pre-charging output nodes to the supply voltage during a pre-charge phase every clock cycle and conditionally discharging some of them, depending on the inputs during the evaluation phase. These techniques are energy inefficient since all of the charge discarded to the reference ground potential during evaluate must be resupplied during the precharge phase of the next clock cycle. High peak currents can also cause large di/dt noise causing voltage bumps in power rails associated risks to signal integrity and reliability in high performance CMOS components.

Dynamic logic circuits that recycle some of the charge were proposed to improve the energy efficiency of circuit operation. These circuit techniques precharge complementary outputs to half $V_{DD}$ by charge sharing from the previous evaluation state, enabling a maximum of a 50% reduction in energy. Such schemes are relevant only when complementary signal pairs are used in implementing complex logic functions. Also, much of the charge recycle benefits are lost with performance degraded as well due to (i) high overheads in device count (ii) requirement of using complementary inputs and as many as 2-3 clock and enable inputs to each logic gate with their associated additional routing, performance and power overheads (iii) use of cross-coupled inverters as output drivers which increase the uncertainty of gate metrics in the presence of parameter variations and the offsets they develop, and (iv) with only a half-VDD gate-source voltage precharged to output and input nodes of output drivers for charge recycle operation, gate overdrive is degraded during evaluation phase. In one comparison with static CMOS implementing full adders, the power-delay product of a full adder increases total energy nearly 10% over static CMOS. Moreover, neural network energy consumption is dominated by movement of data across the memory hierarchy and the chip and not by dissipation from computation.

On-chip small voltage swing signaling. schemes have attempted charge recycling by stacking components (such as logic and clocking circuits) with predictable data switching activities in two adjacent voltage domains using simple push-pull regulators to balance current between the two domains to maintain the voltage at their interface. This approach could deliver a maximum of a quadratic reduction in power. Inefficiency introduced by voltage regulation is eliminated if the current between domains is matched. An approach to stack voltage domains without requiring regulators between them has been reported using a balanced charge recycling bus where differing data activity between two links is compensated by swapping data between them periodically so that switching activity along the bus is exactly matched. These schemes however, are difficult to implement and also require circuits in the domains to be powered by reduced operating voltages.

Charge recycling techniques have been reported where the flow of electric charge from the supply rail ($V_{DD}$) to Ground is traced through more than one circuit/use through multiple voltage domains. However, there is no energy advantage from recycling the charge through multiple voltage domains since it costs as much in energy to raise charge to the highest voltage domain as it does to de so cumulatively in each of the. stacked domains operating independently. The energy advantage of stacking voltage domains is only in removing the inefficiencies of on-chip voltage regulation from $V_{DD}$ to much lower voltages that these domains would be powered with to benefit from quadratic reductions in their switching power. If the current between domains is not matched, the energy overhead consumed by regulators attempting to maintain domain interface at a fixed voltage, could diminish the quadratic energy improvements from operating each domain at reduced voltages.

Non-resonant approaches to returning/recycling stored on load capacitance include use of an inductor to discharge load capacitor of a clock network to the power grid instead of it being discharged to ground. However, overheads of inductors, decoupling capacitors, integration with clock gating (and its accompanying overheads), and limited application to large clock load capacitances (as seen in a clock mesh) are challenges seen with this approach making it impractical and difficult to implement.

Smaller voltage transitions for each logic, operation using 'recycled charge' also with the disadvantages of smaller margins and lower performance. In multiple instances, these make implementations impractical. For e.g., a smaller (than $V_{DD}$) voltage is applied across a BL pair during an SRAM Write operation to enable lower energy dissipation per Write Operation. By sharing/recycling charge across a set of BL pairs, Writes are attempted with smaller voltage swings on the BL (instead Of full rail-rail BL swings during a conventional SRAM Write). For small geometry devices it becomes harder to write to the bitcell even with the full supply voltage across a bit line pair -due to increasing electrical variability seen in small-geometry bitcell transistors. Circuit overheads introduced by full CMOS transmission gates to move charge between columns comes at a significant cost in area, control and performance.

Adiabatic switching in reversible logic circuits moves charge from the power supply to a load capacitance using slow constant current charging without energy dissipation. It enables the recycling of energy to reduce the total energy drawn from the power supply by reversing the current source using non-standard AC or pulsed power supplies with time varying voltage or current. In sharp contrast to conventional CMOS circuit operation, charge and energy are not discarded after being used only once - with pulsed/sinusoidal cower supplies designed to be able. to retrieve the energy fed back to it. The problem areas limiting realization of practical low-power operation of CMOS chips using adiabatic or reversible logic techniques; (1) the energy-efficient design of the combined power supply and clock generator (2) logical overhead needed to support reversible logic functions and (3) the alternative of scaling operating voltages with feature size and improving performance - that comes with conceptual simplicity and high payback of lower power dissipation, has: been preferred by industry.

## Summary

Conventional CMOS operation as illustrated by an inverter driving a capacitive load C and which draws energy equal to $CV_{DD}^2$ from the power supply rail at voltage $V_{bb}$ during a $0{\rightarrow}1$ transition at its output, of which energy equal to $(1/2)CV_{DD}^2$ is stored at the output. A $1{\rightarrow}0$ transition at the output discharges all of this stored energy to the reference ground potential of the inverter at voltage Vss = 0V.

In the proposed invention, an inverter driving the same capacitive load C as the above conventional CMOS inverter, draws energy equal to $\alpha CV_{DD}^2$ (where $\alpha$ is a positive fraction < 1) from a grid/node capacitance holding harvested electrostatic charge at some intermediate electric potential V2 where V2 $\geq$ Vss and V2 $\leq V_{DD}$ as the inverter uses this harvested charge to drive a $0{\rightarrow}1$ transition at its output, until the output voltage approaches V2 when the proposed circuit invention continues driving the output to $V_{DD}$ using electric charge from the power grid of the chip at electric potential $V_{DD}$ while consuming energy equal to only $\beta CB_{DD}^2$ where $\beta$ is a positive fraction < 1) with a $\alpha + \beta \sim 1$. Typical values of $\beta$ are 0.6 - 0.75.

## Brief Description of Drawings

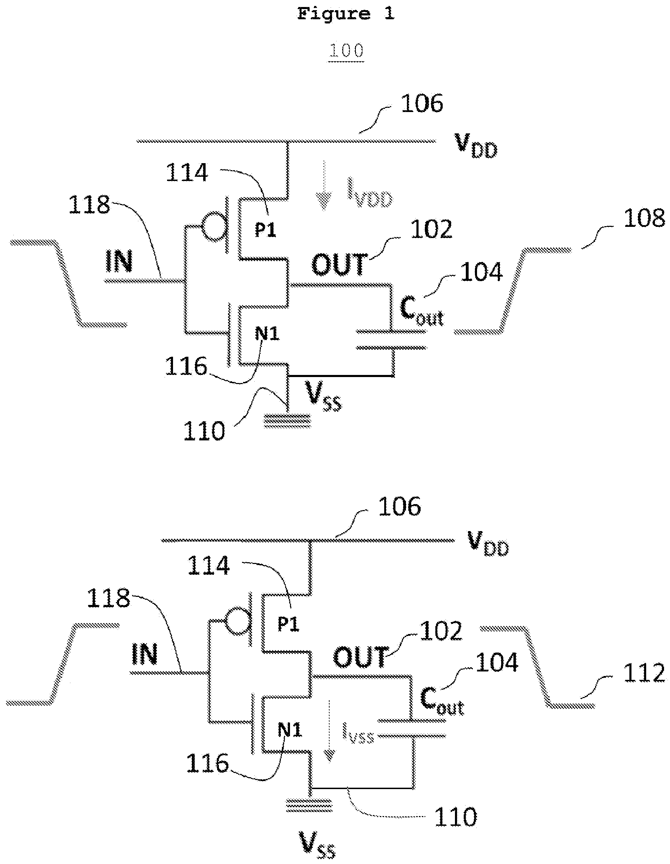

Figure 1 is a schematic illustrating conventional CMOS circuit schematic of an inverter and its operation in response to $1{\rightarrow}0$ and $0{\rightarrow}1$ input transitions.

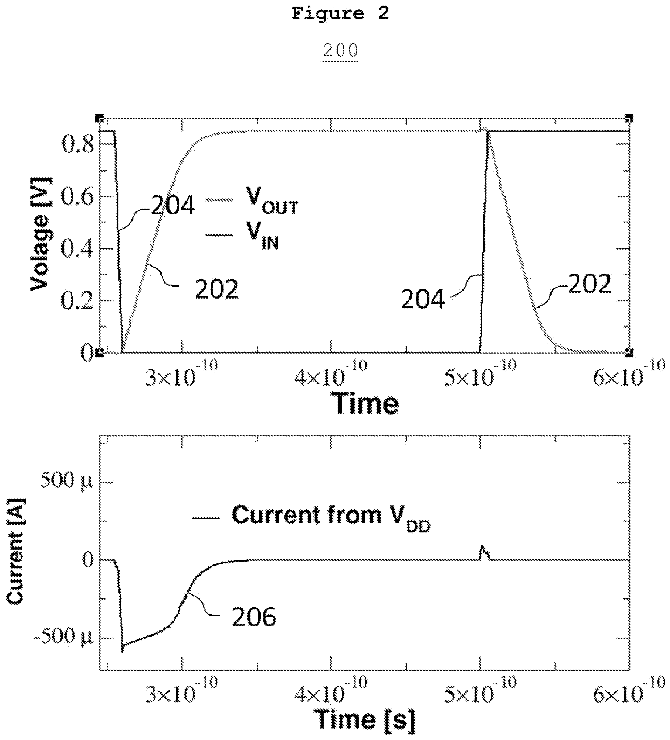

Figure 2 is a circuit simulation: of the conventional CMOS inverter circuit that shows voltage waveforms at the input and at the output terminals of the inverter in response to $1{\rightarrow}0$ and $0{\rightarrow}1$ input transitions. The Figure also shows the current waveform that illustrates the current flow dependence on time for the $0{\rightarrow}1$ transition at the output and the $1{\rightarrow}0$ transition at the output.

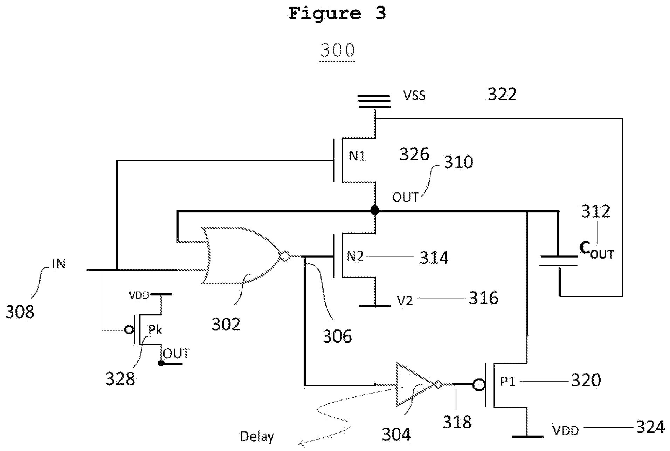

Figure 3 is a schematic illustrating the proposed circuit Of an inverter that uses harvested charge held at a grid/node capacitance at any voltage (between the power rails at the supply voltage and the reference ground potential) to drive its output during a $0{\rightarrow}1$ voltage transition at an energy Cost of 0.6x - 0.75x of that seen in a conventional CMOS inverter.

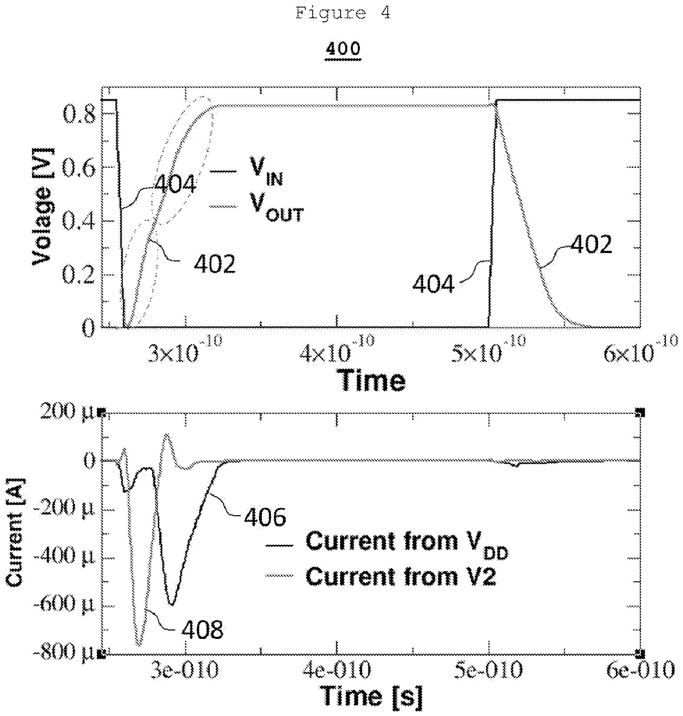

Figure 4 is a circuit simulation of the proposed inverter circuit that uses harvested charge to power the $0{\rightarrow}1$ voltage transition at its output - showing voltage waveforms at the input and output terminals (that are practically identical to those observed in a conventional CMOS inverter (Figure. 2)) and current waveforms corresponding to current drawn from the grid holding harvested 6harge at VDD/2 and the current drawn from the power rail at voltage = VDD.

**Detailed Description**

Figure 1 is a schematic illustrating operation of a conventional CMQS inverter 100 driving output node OUT **102** with a capacitive load $C_{out}$ **104.** The power rail **106** at electric potential $V_{DD}$ provides total energy equal to $C_{out}V_{DD}^2$ (derived in equation (1) below) during a $0\to1$ transition **108** at the output node OUT **102,** storing energy of $(1/2)C_{out}V_{DD}^2$ on the capacitor **104** at the output **102** modeled by equation (2) below. A $1\to0$ **112** transition at the output **102** discharges from $C_{out}$ **104** all of this stored energy on the capacitor $C_{out}$ **104** at the output **102** to the reference ground node **110** at electric potential Vss = 0V

*Energy drawn from VDD supply (during 0→1 transition at output)*

$$\int I_{VDD}(t)\, V_{DD}\, dt = \int_{VSS}^{VDD} C_{out} V_{DD}\, dV_{out} = C_{out} V_{DD}^2 \tag{1}$$

*Energy stored at output*

$$\int I_{VDD}(t)\, V_{out}(t)\, dt = \int_{VSS}^{VDD} C_{out} V_{out}\, dV_{out} = \tfrac{1}{2} C_{out} V_{DD}^2 \tag{2}$$

*Energy discharged from output (during 1→0) transition at output)*

$$a. \quad \int I_{VSS}(t)\, V_{out}(t)\,dt = \int_{VDD}^{VSS} C_{out} V_{out}\, dV_{out} = \tfrac{1}{2} C_{out} V_{DD}^2 \tag{3}$$

Figure 2 **200** is an illustration of the time dependent voltage waveforms of the output node OUT (**102** in Figure 1 **100**) shown as the waveform $V_{out}$ **202** in Figure 2. The voltage waveform driving the input of the inverter **118** in Figure 1, is shown in Figure 2 as $V_{DD}$ **204**

The waveform of current flow **206** into the inverter from the power rail at voltage $V_{DD}$ (**106** in Figure 1) is shown along the same x-axis of time (as used to plot voltage waveforms) in Figure 2. The absolute value of the integral of the current waveform **206** over time in Fig 2 **200** equals the total charge Q drained from the Power rail (**106** in Fig 1) to drive the output node **102** from $0\to1$. The energy consumed from the power rail **106** to accomplish this logic transition at the output node **102** equals $[Q\cdot V_{DD}] = C_{out}V_{DD}^2$ modeled in equation (1) above.

In Figure 3 the proposed circuit schematic functioning as an inverter **300** shows parts highlighted in blue: a 2-input NOR **302** and a delay element **304** that also inverts. These highlighted parts have devices with much smaller widths (~1/5 of driver transistors) than the other transistors (**326, 314, 320**) shown in black in this schematic **300.**

The NOR gate **302** in this schematic generates an *active high pulse* at its output node **306** whose leading edge is triggered by a $1\to0$ transition at the input **308** and whose trailing edge is triggered by a $0\to1$ transition at the output node **310** loaded with a total capacitance $C_{OUT}$ **312.**

The leading edge of this active high pulse turns on NFET N2 **314** which drives charge harvested on the V2 node **316** (held at a voltage typically between VSS and VDD and preferably at a voltage comparable to the logic threshold of the NOR gate **302**) to the output node **310** of this inverter.

The leading edge of the, active high pulse at the *output of the NOR gate* **306,** when delayed and inverted to drive the gate input **318** of PFET PI **320,** turns on PFET PI **320** to begin charging the output **310** to $V_{DD}$ - as the output voltage at node OUT **310** approaches V2. Note that a design requirement on the logic threshold voltage of the NOR gate **302** is that it is lower than the typical voltage node V2 would be raised to with harvested charge. Thus, node OUT **310** when being charged to V2 through NFET N2 **314,** can trip the NOR **302** to produce the high$\to$low transition of the active high pulse at *output of the NOR* gate **306** to turn-off N2 **314.**

The NOR **302** would also trip when the P channel FET PI **320** begins conducting after the delayed and inverted leading edge of the active high pulse output from the NOR turns on P1 **320.**

The output continues being charged to VDD by the power rail **324** as P1 **320** is turned on. The trailing edge of the active low pulse driving the gate input terminal of the P channel FET **320** turns this PFET **320** off. A small geometry keeper HVT PFET **328** holds the output to $V_{DD}$. Its gate input is driven by the inverter input **308** with its source terminal connected to the power rail **324** at voltage $V_{DD}$ and its drain terminal connected to OUT **310.**

The trailing edge of the active high pulse at the *output of the NOR* **306** is triggered by the transition at the output

EP 4 358 409 A1

node from 0→V2 since the logic threshold of the NOR **302** is less than the voltage at which node V2 **316** is charged to with harvested charge, the trailing edge is triggered by this feedback from OUT **310** to the *output of the NOR* **306**.

The proposed circuit (1) maintains rail-rail operation (2) drives practically the same waveforms at its output as a conventional inverter and (3) uses about 25% - 40% of the total charge it drives to its output **310** - from the harvest grid node V2 **316**, *instead of getting that charge from the VDD supply rail* **324.** The primary overhead in area is consumed by the NFET N2 in Fig 3. All of the other transistors highlighted in blue in Figure 3 are small and can be replaced by equivalent standard cells. Transistors PI **320**, NI **326** in Figure 3 are identical to the transistors 116 and 114 in the schematic of the inverter in Figure **1 100.**

The NOR gate **302** and the delay element **304** can be optimized to maximize the energy used from the grid/node holding harvested charge according to what voltage the harvested charge is typically held at when using the proposed inverter. The closer the voltage of the harvested charge is to VDD, the higher the optimal logic threshold voltage of the NOR gate **302** is optimized at and the longer the delay value of the delay element **304** needs to be to maximize the use of harvested charge to accomplish the same 0→1 transition at the output of the inverter. This optimization is especially useful when operating at low, near threshold voltages

Figure 4 **400** is an illustration of the time dependent voltage waveforms Of the output node OUT **(310** in Figure 3) shown as $V_{OUT}$ **402** in Figure 4. The input waveform driving the input 308 of the inverter in Figure 3, $V_{IN}$ **404** is also shown in Figure 4.

The waveform of current flow **406** into the inverter from toe VDD power rail **(324** in Figure 3) is shown along the same x-axis (as used to plot voltage waveforms) in Figure 4. The absolute value of the integral of Current over time in Fig 4 **400** equals the total charge Q drained from the power rail **(324** in Fig 3) to drive the output from 0→1. Note that initially the charge to drive the output in the 0→1 transition comes from the harvest charge grid / node V2 **316** in Figure 3. The total charge driven to node OUT **310** in Fig 3 is the total area under the curves 406 and 408 in Figure 4. This sum approximately equals the area under the current waveform **206** in Figure 2 for the conventional CMOS inverter. Note that the voltage waveform at the output node **310** in Figure 3 is practically the same as the voltage waveform of the output node **102** in Figure 1 **100** of a conventional inverter. However, for the schematic in Figure 3 **300** the total charge consumed from the power rail to complete the 0→1 transition at the output node **310** is only 60% - 75% of the total charge taken from the power rail **106** in Figure 1 for a conventional CMOS inverter. Total current in the comparison is based on simulation of the entire circuit shown in Fig 1 **100** and Fig 3 **300** - and thus includes parasitic contributions of all transistors to circuit operation. All parasitic capacitances Of transistors in the complete schematic contribute to slew rate seen at the output and overheads incurred in propagation delay in the schematic.

Switching energy Consumption by logic gates with low fanouts ( < 4) are typically small. Gates driving a high fanout (> 10) and/or long wires consume more energy and are best candidates for the proposed scheme that uses harvested charge.

The transistor energy increases in the proposed schematic shown in Fig 3 **300** compared to the 2 transistors used in a conventional CMOS inverter. However, the area consume by the proposed schematics in Fig 3 **300** *does not* increase proportionally with the number of translators because the transistors of gates highlighted in blue **(302, 304** in **Fig 3)** are ~5X smaller than any of the transistors drawn in black **(326, 314** and **320** in **Fig 3 300).** This because the load seen by the NOR gate **302** highlighted in blue is small - essentially just the gate input, of a single NTFT(N2 **314** in **Fig 3)-** with the load from the delay element **304** much smaller. The transistors PI **320**, N1 **326** and N2 **314** in Fig 3 are comparable (in dimensions) to the transistors PI **114** and N1 **116** in a conventional CMOS inverter shown in Fig **1100** that drives the same capacity load $C_{OUT}$ **104** in **Fig 1** and **312** in **Fig. 3.** The gate footprint of the proposed schematic **300** (in Fig 3) is not expected to be larger than 1.7X - 2.0X of the CMOS inverter it replaces. Note that the proposed schematics are preferred as replacement candidates of CMOS inverters only when driving large loads - that offer the opportunity for larger energy reductions.

Although illustrative embodiments of the present invention have been described herein, it is to be understood that the invention is not limited to those precise embodiments, and that various other changes and modification may be made by one skilled in the art without departing from-the scope of the invention.

**Claims**

1. An inverter, comprising:

   a first N-channel FET [field effect transistors] and a first P-channel FET with their drain terminals shorted together at an output terminal of the inverter, a source terminal of the first N-channel FET being connected to a reference ground supply rail, a source terminal of the first P-channel FET being connected to a power supply rail;
   a second N-channel FET having a source terminal and a drain terminal coupled to the output terminal with a grid/node having a capacitance configured to hold harvested charge at a voltage larger than a reference ground potential;

an input terminal and the output terminal of the inverter configured such that electric potentials make full-swing transitions between a voltage of the power supply rail and a voltage of the reference ground rail, the input terminal of the inverter connected directly to a gate input terminal of the first N-channel FET,

a second P-channel FET having a gate input terminal configured to be driven by the input terminal of the inverter and having a source terminal a drain terminal that are connected to the power supply rail at a voltage VDD and to the output terminal of the inverter,

a 2-input NOR gate having inputs configured to be driven by, the input terminal and the output terminal of the inverter, the 2-input NOR gate output configured to drive the gate input terminal of the second N channel FET and the input terminal of a delay element configured to have an inverted output that drives the first P-channel FET.

2. The inverter as recited in claim 1, wherein the second N-channel FET is configured to move the harvested charge from the grid/node to the output terminal of the inverter following a $1 \rightarrow 0$ logic transition at the input terminal of the inverter with charge transfer being self-disabled by a rising inverter output voltage that resets an output of the 2-input NOR gate to the reference ground potential as the inverter output voltage approaches a logic threshold voltage of the 2-input NOR gate.

3. The inverter as recited in claims 2, wherein the rising inverter output voltage is reinforced by the first P-channel FET of the inverter when a delayed, leading-edge of a $1 \rightarrow 0$ logic transition at the gate input terminal of the first P-channel FET completes a $0 \rightarrow 1$ transition at the output of the inverter by transferring charge from the power rail to the output of the inverter.

4. The inverter as recited in claims 1, 2 or 3, wherein:

   the 2-input NOR gate having a logic threshold comparable to the voltage of the harvested charge ;
   the delay element configured to provide a delay that is comparable to a time for a voltage of the output to rise to the voltage comparable to the logic threshold of the 2-input NOR gate.

5. An apparatus, comprising:

   an input terminal of an inverter;
   an output terminal of the inverter;
   a first p-channel field-effect transistor (FET);
   a first n-channel FET coupled to shortened drain terminals of the first p-channel FET and the output terminal of the inverter, the first n-channel FET having a source terminal configured to be connected to a ground and having a gate terminal connected to the input terminal of the inverter, the first p-channel FET having a source terminal configured to be connected to a power supply rail;
   a second n-channel FET having a source terminal connected to the output terminal of the inverter and a drain terminal connected to a harvest charge node;
   a second p-channel FET having a gate terminal configured to be driven by the input terminal of the inverter, the second p-channel FET having a source terminal configured to be connected to the power supply rail and a drain terminal configured to be connected to the output terminal of the inverter; and
   a NOR gate with a first input terminal and a second input terminal, the first input terminal and the second input terminal of the NOR gate being connected with and configured to be driven by the input terminal and the output terminal of the inverter, the NOR gate having an output terminal connected to the gate input terminal of the second n-channel FET and the input terminal of a delay element that has an inverted output terminal connected with the first p-channel FET of the inverter.

6. The apparatus of claim 5, wherein the output terminal of the inverter is configured to be coupled to a capacitance node, the capacitance node configured to hold harvested charge at a voltage larger than the ground.

7. The apparatus of claim 5, wherein:

   the output terminal of the inverter is configured to be coupled to a capacitance node, the capacitance node configured to hold harvested charge at a voltage larger than the ground, and
   the delay element and the NOR gate are configured to maximize an output voltage from the harvested charge stored in the capacitance node based on a voltage threshold for the harvested charge stored in the capacitance node.

8. The apparatus of claim 5, wherein:

the output terminal of the inverter is configured to be coupled to a capacitance node, the capacitance node configured to hold harvested charge at a voltage larger than the ground,

the delay element and the NOR gate are configured to maximize an output voltage from the harvested charge stored in the capacitance node based on a voltage threshold for the harvested charge stored in the capacitance node, and

the NOR gate is configured to be tripped based on a logic threshold voltage associated with the NOR gate, the logic threshold voltage increasing based on an increase in the output voltage from the harvested charge stored in the capacitance node.

9. The apparatus of claim 5, wherein:

the output terminal of the inverter is configured to be coupled to a capacitance node, the capacitance node configured to hold harvested charge at a voltage larger than the ground,

the delay element and the NOR gate are configured to maximize an output voltage from the harvested charge stored in the capacitance node based on a voltage threshold for the harvested charge stored in the capacitance node,

the NOR gate is configured to be tripped based on a logic threshold voltage associated with the NOR gate, the logic threshold voltage increasing based on an increase in the output voltage from the harvested charge stored in the capacitance node, and

the delay element is configured to increase a delay value of the delay element based on an increase of the logic threshold voltage associated with the NOR gate.

10. The apparatus of any of claims 5 to 9, wherein the NOR gate is configured to be tripped to produce a high-low transition at the input terminal of the delay element, based on a charge transfer from the output terminal of the inverter to the harvest charge node via a rising voltage through the second n-channel FET.

11. The apparatus of any of claims 5 to 10, wherein the first p-channel FET is configured to be driven by a delayed and inverted leading edge of an active high pulse at the output terminal of the NOR gate, to increase a voltage at the output terminal of the inverter to approach a voltage of the power supply rail, as the voltage at the output terminal approaches a voltage at the harvested charge node.

12. The apparatus of any of claims 5 to 11, wherein an output voltage at the output terminal of the inverter can be configured to trip the NOR gate based on a voltage at the output terminal of the inverter approaching a voltage at the harvest charge node, to turn off the second n-channel FET.

13. The apparatus of any of claims 5 to 12, wherein the NOR gate is configured to be tripped based on the first p-channel FET being triggered by a delayed and inverted leading edge of an active high pulse output from the NOR gate.

14. The apparatus of any of claims 5 to 13, wherein a trailing edge of an active low pulse from the NOR gate is configured to drive the gate terminal of the first p-channel FET and turn of the first p-channel FET.

## Figure 1

<u>100</u>

Figure 2

200

## Figure 3

300

Figure 4

400

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/321123 A1 (BHAVNAGARWALA AZEEZ [US]) 6 October 2022 (2022-10-06) * paragraph [0003] – paragraph [0037]; claims 1-4; figures 1-4 * | 1-14 | INV. H03K19/00 G01R19/165 |
| A | US 2016/254844 A1 (HULL JONATHAN J [US] ET AL) 1 September 2016 (2016-09-01) * paragraph [0002] – paragraph [0053]; figures 1-15B * | 1-14 | |
| A | US 2017/116443 A1 (BOLIC MIODRAG [CA] ET AL) 27 April 2017 (2017-04-27) * paragraph [0002] – paragraph [0048]; figures 1-11 * | 1-14 | |

TECHNICAL FIELDS
SEARCHED (IPC)

H03K
G01R
G06F

The present search report has been drawn up for all claims

| Place of search | Date of completion of the search | Examiner |
|---|---|---|
| Munich | 28 March 2023 | Kassner, Holger |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
 
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 20 2622

This annex lists the patent family members relating to the patent documents cited in the above-mentioned European search report.
The members are as contained in the European Patent Office EDP file on
The European Patent Office is in no way liable for these particulars which are merely given for the purpose of information.

28-03-2023

| Patent document cited in search report | | Publication date | Patent family member(s) | Publication date |
|---|---|---|---|---|
| US 2022321123 | A1 | 06-10-2022 | NONE | |
| US 2016254844 | A1 | 01-09-2016 | NONE | |
| US 2017116443 | A1 | 27-04-2017 | NONE | |

EPO FORM P0459

For more details about this annex : see Official Journal of the European Patent Office, No. 12/82